# EUROPEAN PATENT APPLICATION

(11) **EP 1 286 423 A2**
(43) Date of publication of application: **26.02.2003**
(21) Application number: 02015022.3
(22) Date of filing: 05.07.2002
(51) Int. Cl.: H01R 12/20

(54) **An electrical connector for a printed-circuit board**

(30) Priority: 22.08.2001 DE 20113884 U
(71) Applicant: ITT MANUFACTURING ENTERPRISES, INC., Wilmington, Delaware 19801 (US)
(72) Inventor: Gollhofer, Martin, 70736 Fellbach (DE); Etzkorn, Roland, 71394 Kernen i.R. (DE); Zeeb, Wolfgang, 73630 Remshalden (DE); Hutt, Wolfgang, 71384 Weinstadt (DE); Stache, Michael, 71384 Weinstadt (DE)
(74) Representative: Dreiss, Fuhlendorf, Steimle & Becker

(57) **Abstract**

An electrical connector (10) comprises an insulating enclosure (12) for the accommodation of contacts (13) and a punched solder board (25) held on one side of the enclosure (19) for the purpose of soldered connection to a printed circuit board (11). The solder board (25) fastened by means of recesses (28 to 30) to integral insulating pegs (33 to 35) projecting from the side of the enclosure (19). Further the solder board (25) is provided in the region of each recess (28 to 30) with a tongue (48 to 50) between whose free end and the opposite edge region (41 to 43) of the recess (28 to 30) the insulating peg (33 to 35) can be clamped.

## Description

### Specification

The present invention relates to an electrical connector according to the preamble of Claim 1.

In regard to an electrical connector of this kind disclosed in EP 0 930 812 A2, the insulating pegs which hold the solder board are constructed as hot-deformable rivets, which means that the solder board is joined to the insulating enclosure by means of the insulating pegs by the hot-riveting method. A mechanical connection is thus produced by means of a selective hot-deformation which should not adversely affect either the insulating enclosure or the contacts in question. The aforesaid is difficult and requires a separate manufacturing step.

The problem addressed by the present invention is to provide an electrical connector of the kind mentioned above, in regard to which the mechanical connection between the solder board and the insulating pegs of the insulating enclosure may be effected in an easier and faster manner.

In order to solve this problem, the features specified in Claim 1 are provided in an electrical connector of the kind referred to.

The process step of hot deformation is avoided by the features according to the invention and is replaced by a simpler, purely mechanical step. Since the solder board must in any case be placed over the insulating pegs onto the insulating enclosure, it is easy in terms of tooling to clamp the solder board onto and over the insulating pegs in the region of the tongues.

The features according to Claim 2 are provided in order to simplify placing without adversely influencing clamping. In this connection, the features according to Claim 3 may be provided for this purpose and for the purpose of better insertion. Moreover, the features according to Claim 4 and/or 5 may expediently be realised.

The features of Claim 6 and/or 7 relate to a preferred arrangement of the tongues.

Further details of the invention will be understood from the following specification, in which the invention is more particularly described and explained with reference to the embodiment shown by way of example in the drawing. In the drawing,
- Fig. 1: is a diagrammatic side view of an electrical connector according to a preferred embodiment of the present invention shown by way of example and connected to a printed circuit board,
- Fig. 2: is an enlarged representation of a perspective view from underneath in the direction of Arrow II in Figure 1, showing only the insulating enclosure of the electrical plug-in connector,
- Fig. 3: is a plan view of the solder board before connection to the insulating enclosure, and
- Figures 4A and 4B: are enlarged perspective representational views according to Arrow IVA and IVB respectively in Figure 2.

The electrical plug-in connector 10 according to a preferred embodiment shown by way of example in the drawing serves respectively for electrical and mechanical connection and fastening to and on a printed circuit board 11 and, in a manner not shown, for plug-in connection to a mating connector which, for example, is provided on a printed circuit board disposed perpendicular to the printed circuit board 11.

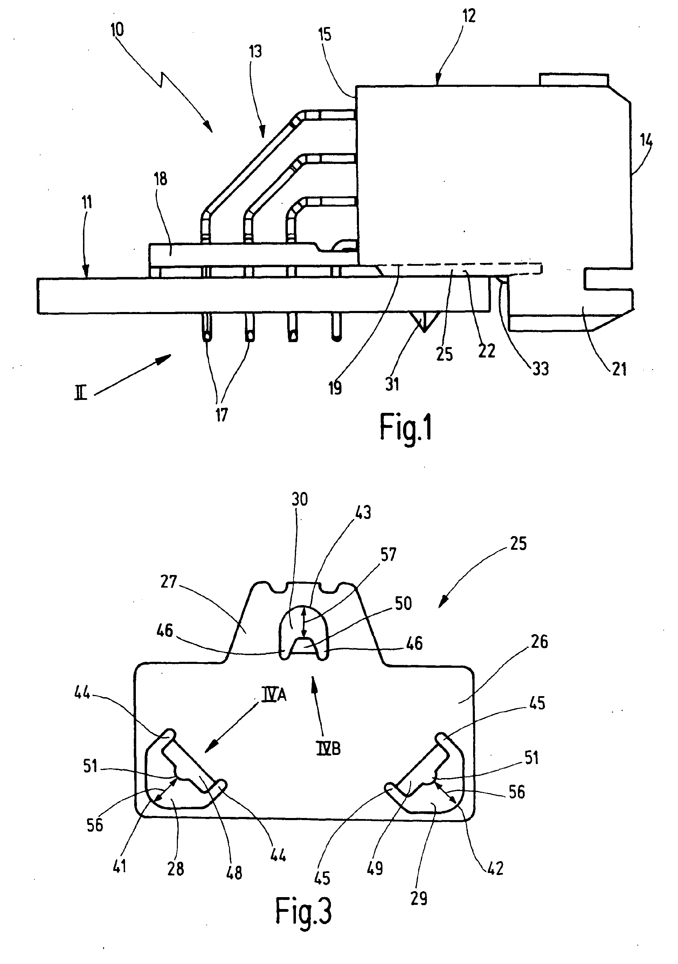

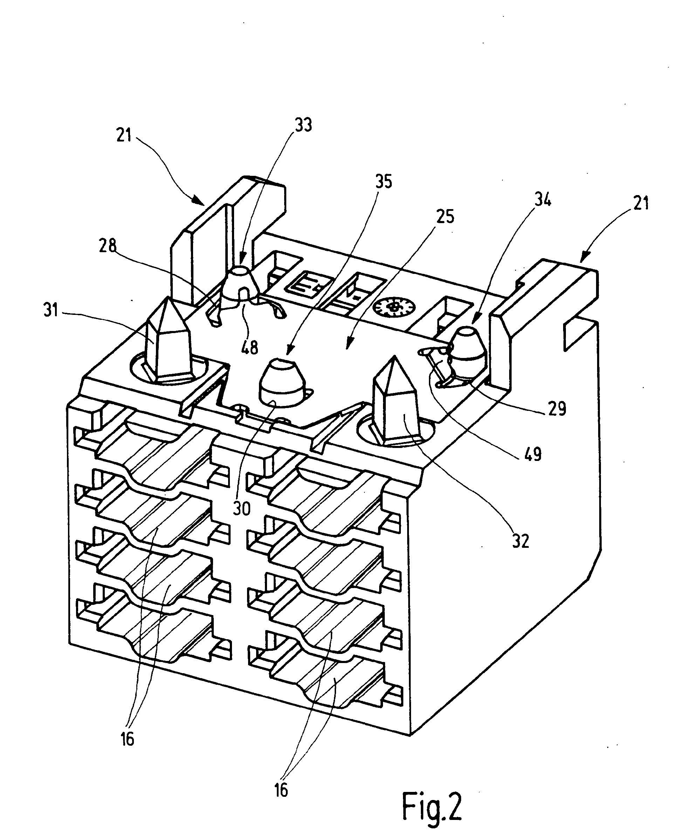

The electrical plug-in connector 10 has a substantially rectangular shaped insulating enclosure 12, in which a plurality of contacts 13 are accommodated disposed at a spacing. As shown in Figure 2, the insulating enclosure 12 has several recesses 16 passing through from a rear side 15 to a front side 14, into which recesses the contacts 13 are inserted by their end which accommodates a contact pin or is of bushing type, from the rear side 15 up to the front side 14, at which the plug-in connector 10 may be connected to a mating connector in a manner which is not shown. According to Figure 1, the pin-like contacts 13 are bent through 90° with an intermediate oblique region and have a pin-like shape for example, at their other end 17. These pin-like ends 17 are spaced apart by means of a perforated holding plate 18. According to Figure 1, the pin-like ends 17 are inserted into plated-through bore holes of the printed circuit board 11 and soldered.

As shown in Figure 1, the insulating enclosure 12, when in the state of being connected to the printed circuit board 11, rests by means of a part region also on the printed circuit board 11, wherein the underside 19 of the insulating enclosure 12 protrudes in relation to the underside of the holding plate 18 so that the holding plate 18 is disposed at a slight spacing from the printed circuit board 11. The underside region of the insulating enclosure 12 which is not disposed on the printed circuit board 11 is provided with lateral slotted wings 21, which serve for connection to a mating connector by insertion in a manner not shown. As can further be seen with reference to Figure 2, the underside 19 of the insulating enclosure 12 is provided with a depression 22, in which a punched solder board 25 is inserted and mechanically secured. The solder board 25 is or becomes mechanically secured by a soldered connection using tin-lead solder to a corresponding contact layer of the printed circuit board 11.

In addition to two outside positioning pins 31 and 32 adjacent to the rear side 15, the underside 19 of the insulating enclosure 12 furthermore has three fastening pegs 33, 34 and 35, of which the first fastening peg 35 is disposed between the two positioning pins 31 and 32 and the second and third fastening pegs 33 and 34, which are substantially identical, are disposed opposite one another between the two wings 21. All positioning pins 31 and 32 and fastening pegs 33 to 35 protrude integrally from the underside 19 of the insulating enclosure 12, thus being made of the same insulating and synthetic material as the enclosure 12. The positioning pins 31 and 32 are longer than the fastening pegs 33 to 35. While the positioning pins 31 and 32 are approximately rhomboidal in cross section, the fastening pegs 33 to 35 have an approximately cylindrical or truncated semi-cylindrical circumference.

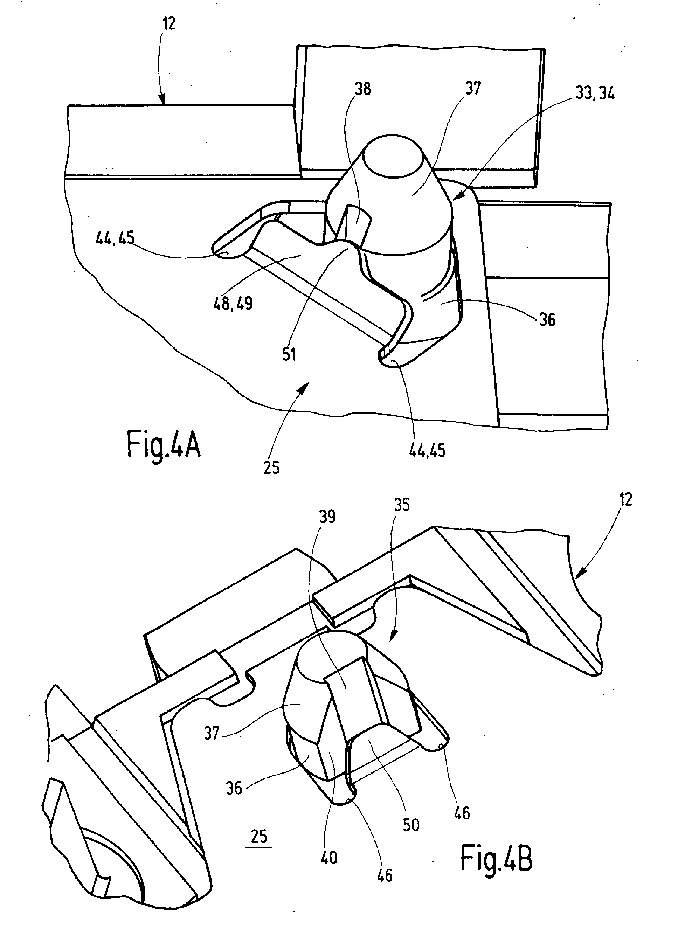

The solder board 25 is fastened mechanically to the fastening pegs 33, 34 and 35, the arrangement of which define the corners of a triangle. The solder board 25, which is punched from a thin metal sheet, has a base surface which is made up of a rectangle 26 and of a trapezium 27 centrally adjoining one long side of the rectangle (Figure 3). Opposite the trapezium 27 in the corners of the rectangle 26, a second and a third recess 28 and 29 are each provided to receive the second and third fastening peg 33 and 34 and, in the trapezium region 27, a first recess 30 to receive the first fastening peg 35.

The first recess 30 and also the second and third recess 28, 29 have a curved region 41, 42 and 43 respectively, which region corresponds to the respective circumferential region of the fastening pegs 33, 34, 35, and opposite the said region, a tongue 48, 49 and 50, each of which is flexibly movable by means of a lateral punched-out region 44, 45 and 46. While the tongue 50 of the first recess 30 has an approximately trapezoidal shape, the tongues 48 and 49 of the second and third recesses 28, 29 are provided rectangle-shaped in identical manner with a central nose 51.

According to Figure 2 and to Figures 4A and 4B, the three fastening pegs 33 to 35 are substantially cylindrical at their base 36 and integrally moulded with the underside 19 of the insulating enclosure 12 and are substantially frusto-conical at their free end 37 seated on the base 36. The second and third fastening peg 33, 34 is provided with a groove 38 to receive the nose 51 of the tongue 48 and 49 respectively, the cylindrical base 36 being provided with a flattened region in the region of the groove 38 extending from the frusto-conical end 37. The first fastening peg 35 has a groove 39 extending from its free end and a flattened region 40 both in the region of the frusto-conical end 37 and in the region of the cylindrical base 36. The groove 39 has a shape and a width corresponding to the tongue 50.

For the purpose of achieving a mechanically stable connection, the respective spacing 56 and 57 between the free end of the tongue 48 and 49 and the curved region 41, 42, and the spacing 57 between the tongue 50 and the curved region 43 of the recess 28, 29 and 30 is somewhat smaller than would correspond to the inside measurement between the ground of the respective groove 38, 39 and the opposite outer circumferential region of the fastening peg 33 to 35. Thus where the solder board 25 is inserted in the position represented in Figure 2 over the fastening pegs 33 to 35, the said fastening pegs penetrate the recesses 28 to 30, wherein the tongues 48 to 50 engage in the grooves 38, 39, and are deflected flexibly there, on account of the different spacing proportions, opposite the direction of movement of the solder board 25 towards the underside 19 of the insulating enclosure 12. During this movement or at the end of the movement, at which the solder board 25 rests with its inner side on the underside 19 of the insulating enclosure 12, the tongues 48 to 50 are pressed towards the underside 19 of the insulating enclosure 12 with the aid of tool plungers which are not shown, so that a mechanically stable clamping of the solder board 25 to and around the fastening pegs 33 to 35 is effected. Detachment of the solder board 25 in the reverse direction is not possible on account of the directional clamping.

While the mechanical clamping of the solder board 25 to an electrical plug-in connector 10 has been described above, it should be understood that also the insulating enclosures of other components may be mechanically joined to a solder board in this manner.

## Claims

1. An electrical connector (10) having an insulating enclosure (12) for the accommodation of contacts (13) and having a punched solder board (25) held on one side of the enclosure (19) for the purpose of soldered connection to a printed circuit board (11), the solder board (25) being fastened by means of recesses (28 to 30) to integral insulating pegs (33 to 35) projecting from the side of the enclosure (19), **characterised in that** the solder board (25) is provided in the region of each recess (28 to 30) with a tongue (48 to 50) between whose free end and the opposite edge region (41 to 43) of the recess (28 to 30) the insulating peg (33 to 35) can be clamped.

2. A connector according to Claim 1, **characterised in that** the tongue (48 to 50) has lateral punched-out regions (44 to 46).

3. A connector according to Claim 1 or 2, **characterised in that** the insulating peg (33 to 35) has a sloped entry surface (37, 38, 39) opposite the tongue (48 to 50).

4. A connector according to Claim 3, **characterised in that** the sloped entry surface (37, 38, 39) has a width corresponding to the free end of the tongue (48 to 50).

5. A connector according to Claim 3 or 4, **characterised in that** the sloped entry surface (37, 38, 39) is disposed recessed in the outer circumference of the insulating peg (33 to 35).

6. A connector according to at least one of the preceding claims, **characterised in that** the latching tongue (48 to 50) is directed towards the outer edge of the solder board (25).

7. A connector according to at least one of the preceding claims, **characterised in that** the latching tongue (48 to 50) is directed towards a diagonal corner of the solder board (25).
